(19)
Europäisches Patentamt
European Patent Office
Office européen des brevets

(11) **EP 1 664 804 B1**

(12) **EUROPÄISCHE PATENTSCHRIFT**

(45) Veröffentlichungstag und Bekanntmachung des Hinweises auf die Patenterteilung:
**09.04.2008 Patentblatt 2008/15**

(21) Anmeldenummer: **04786838.5**

(22) Anmeldetag: **16.09.2004**

(51) Int Cl.:
***G01R 15/16*** *(2006.01)* ***G01R 15/18*** *(2006.01)*
***G01R 19/25*** *(2006.01)*

(86) Internationale Anmeldenummer:
**PCT/DE2004/002122**

(87) Internationale Veröffentlichungsnummer:
**WO 2005/031374 (07.04.2005 Gazette 2005/14)**

(54) **VERFAHREN UND VORRICHTUNG ZUR SPANNUNGSMESSUNG**

METHOD AND DEVICE FOR MEASURING VOLTAGE

PROCEDE ET DISPOSITIF DE MESURE DE TENSION

(84) Benannte Vertragsstaaten:
**DE FR GB IT**

(30) Priorität: **26.09.2003 DE 10346356**

(43) Veröffentlichungstag der Anmeldung:
**07.06.2006 Patentblatt 2006/23**

(73) Patentinhaber: **SIEMENS AKTIENGESELLSCHAFT**
**80333 München (DE)**

(72) Erfinder: **JURISCH, Andreas**
**16727 Schwante (DE)**

(56) Entgegenhaltungen:
**US-A- 3 870 927**
**US-A- 5 068 598**
**US-A1- 2002 171 433**
**US-B1- 6 236 949**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 664 804 B1

Printed by Jouve, 75001 PARIS (FR)

## Beschreibung

Die Erfindung betrifft ein Verfahren zum Messen der Spannung an einer Stelle eines Stromverteilungsnetzes mittels einer Messschaltung, die einen mit einem stromführenden Leiter des Netzes gekoppelten Spannungsgeber und eine an den Spannungsgeber angeschlossene Weiterverarbeitungsanordnung aufweist und an ihrem Ausgang einen Spannungsmesswert als Ausgangssignal abgibt, sowie eine Vorrichtung zur Durchführung dieses Verfahrens.

In Stromverteilungsnetzen vorzugsweise im Spannungsbereich von 6-20 kV werden für Schutz- und Steuerungszwecke derzeit noch überwiegend Geräte eingesetzt, die einen richtungsunabhängigen Überstromschutz darstellen. Dies ist ausreichend in Netzen mit zentraler Einspeisung, in denen die Stromrichtung vorgegeben ist. Bei dezentraler Einspeisung jedoch ist für das Ansprechen von Schutzeinrichtungen auch erforderlich, dass zusätzlich zur Größe eines Stroms auch dessen Richtung erfasst wird. Diese kann durch zusätzliche Spannungsmessungen im Netz ermittelt werden. Hierzu werden heutzutage üblicherweise induktive Spannungswandler als Spannungsgeber eingesetzt. Diese ermöglichen eine genaue Spannungsmessung, stellen jedoch einen erheblichen Kostenfaktor dar, insbesondere wenn sie nachträglich in bestehenden Netzen installiert werden.

Aus der deutschen Offenlegungsschrift DE 23 25 449 A1 ist zur Spannungsmessung in Hochspannungsschaltanlagen die Verwendung eines kapazitiven Spannungswandlers als Spannungsgeber beschrieben, der aus einem stromführenden Leiter des Hochspannungsnetzes und einer in einem Stützisolator des Leiters eingebetteten Elektrode gebildet ist. Üblicherweise werden solche kapazitiven Spannungswandler heute jedoch lediglich zur Feststellung des Vorhandenseins einer Spannung bestimmter Mindesthöhe auf einer Leitung eines Stromverteilungsnetzes den Verschiebestrom eines Hochspannungs-Koppelkondensators genutzt, da das erhaltene Messergebnis teilweise relativ ungenau ist, so dass es nur zur Feststellung des Vorhandenseins der Spannung, nicht aber zur Bestimmung von deren genauer Höhe verwendet werden kann.

Aus den Patentschriften US-3,870,927 und US-5,068,598 sind Spannungsmessvorrichtungen mit kapazitiven Spannungsteilern als Messschaltung bekannt, bei denen Korrekturglieder verwendet werden, welche Übertragungsfunktion besitzen, die zu der Übertragungsfunktion der Messschaltung invers sind. Aus US-2002/0171433 A1 ist ein Verfahren zur Spannungsmessung an ummantelten Energieversorgungsleitungen bekannt, bei dem die Spannung auf kapazitive Weise gemessen wird. Aus US-6,236,949 B1 geht eine Strommessschaltung hervor, bei der ein Ringkernwandler als Spannungsgeber eingesetzt wird.

Es ist die Aufgabe der vorliegenden Erfindung, ein Verfahren und eine Vorrichtung der oben genannten Art anzugeben, durch die unabhängig von der Art des Spannungsgebers eine genaue Spannungsmessung durchgeführt werden kann.

Diese Aufgabe wird erfindungsgemäß entsprechend dem in Anspruch 1 definierten Verfahren gelöst. Vorteilhafterweise kann bei dem erfindungsgemäßen Verfahren vorgesehen sein, dass als Spannungsgeber der Messschaltung eine Kondensatoreinrichtung verwendet wird. Die Verwendung einer Kondensatoreinrichtung - also eines kapazitiven Span-nungswandlers- als Spannungsgeber stellt nämlich eine vergleichsweise kostengünstige Möglichkeit der Spannungsmessung dar.

In diesem Zusammenhang wird es zudem als vorteilhaft angesehen, wenn als Kondensatoreinrichtung ein aus dem stromführenden Leiter des Netzes und einer galvanisch von diesem getrennten Elektrode gebildeter Koppelkondensator verwendet wird. Solche Kondensatoreinrichtungen besitzen einen vergleichsweise einfachen Aufbau; ferner sind Kondensatoreinrichtungen dieser Art bereits häufig beispielsweise in Hochspannungsdurchführungen von Schaltzellen vorhanden.

Alternativ kann allerdings auch vorteilhaft vorgesehen sein, dass als Spannungsgeber ein primärseitig mit dem stromführenden Leiter verbundener induktiver Spannungswandler verwendet wird. Dies wird insbesondere deshalb als vorteilhaft angesehen, weil ein solcher induktiver Spannungswandler generell eine sehr genaue Spannungsmessung ermöglicht. Da jedoch die Messschaltung auch bei Verwendung eines induktiven Spannungswandlers eine Übertragungsfunktion aufweisen kann, die den Spannungsmesswert geringfügig verfälscht, können bei Einsatz der Korrektur mittels des Korrekturglieds nach dem erfindungsgemäßen Verfahren auch hierbei noch genauere Spannungsmesswerte erzielt werden.

Hierbei wird es jedoch zusätzlich als vorteilhaft angesehen, wenn ein Korrekturglied verwendet wird, das über einen Schalter wahlweise überbrückbar ist. Auf diese Weise kann das Korrekturglied bei ausreichender Genauigkeit der bei Verwendung des induktiven Spannungswandlers erzielten Spannungsmesswerte leicht überbrückt werden; es findet in einem solchen Fall also keine Korrektur der Spannungsmesswerte statt.

Je nachdem, ob das Ausgangssignal der Messschaltung analog oder digital ist, kann als Korrekturglied ein analoges oder digitales Filter mit einer zur Übertragungsfunktion der Messschaltung inversen Übertragungsfunktion zum Einsatz kommen. Das analoge Filter bildet zweckmäßig eine Übertragungsfunktion mit PID-Charakteristik nach.

Bei Verwendung eines digitalen Filters bietet sich als inverse übertragungsfunktion eine zeitdiskrete Übertragungsfunktion an. Diese kann in an sich bekannter Weise mittels einer Bilineartansformation erzeugt werden.

In diesem Zusammenhang wird es zudem als vorteilhaft angesehen, wenn bei dem digitalen Filter die Koeffizienten der zeitdiskreten Übertragungsfunktion veränderbar sind. In diesem Fall lässt sich nämlich die Übertragungsfunktion des Korrekturgliedes besonders einfach an durch unterschiedliche Spannungsgeber hervorgerufene Übertragungsfunktionen der Messschaltung anpassen.

Eine weitere vorteilhafte Weiterbildung des erfindungsgemäßen Verfahrens sieht ferner vor, dass eine Weiterverarbeitungsanordnung verwendet wird, die in ihrem Eingangsbereich ein galvanisches Trennelement aufweist. Auf diese Weise können die Weiterverarbeitungsanordnung und das Korrekturglied nämlich problemlos galvanisch von der Hochspannungsseite getrennt werden.

Hinsichtlich der Vorrichtung wird die der Erfindung zugrunde liegende Aufgabe durch eine Messvorrichtung gemäß Anspruch 8 gelöst.

Aus Kostengründen kann vorteilhafterweise vorgesehen sein, dass der Spannungsgeber eine Kondensatoreinrichtung ist. Gemäß einer bevorzugten Ausführungsform kann es sich bei einer solchen Kondensatoreinrichtung ferner um einen aus dem stromführenden Leiter des Netzes und einer galvanisch von diesem getrennten Elektrode gebildeten Koppelkondensator handeln. Eine solchermaßen ausgestaltete Elektrode kann vorzugsweise eine sogenannte Ringelektrode sein.

Alternativ kann aber auch vorgesehen sein, dass der Spannungsgeber ein primärseitig mit dem stromführenden Leiter verbundener induktiver Spannungswandler ist.

Da ein solcher induktiver Spannungswandler häufig schon Spannungsmesswerte sehr guter Qualität liefert, kann in diesem Zusammenhang ferner vorgesehen sein, dass das Korrekturglied über einen Schalter wahlweise überbrückbar ist.

Allerdings ist auch bei einem induktiven Spannungswandler häufig die Qualität der Spannungsmesswerte durch erfindungsgemäßen Einsatz eines Korrekturgliedes mit inverser Übertragungsfunktion noch weiter steigerbar, so dass sich auch in diesem Fall der Einsatz des - dann folglich nicht überbrückten - Korrekturgliedes lohnt.

Mit anderen Worten weist eine erfindungsgemäße Messvorrichtung z. B. eine Eingangsklemme für den wahlweisen Anschluss an beliebige Spannungsgeber, z. B. an die Elektrode des Koppelkondensators oder an die Sekundärwicklung eines primärseitig an den stromführenden Leiter angeschlossenen induktiven Spannungswandlers auf. Dadurch erhält man hierbei die Möglichkeit, abhängig davon, ob bereits ein Koppelkondensator oder ein induktiver Spannungswandler an der Messstelle im Netz installiert ist, die Messvorrichtung an den entsprechenden Spannungsgeber anzuschließen. Die Messvorrichtung ist dann mit einem Schalter zum wahlweisen Ein- oder Ausschalten des die inverse Übertragungsfunktion nachbildenden Korrekturglieds versehen, um bei einem Anschluss an den Koppelkondensator das Korrekturglied einzuschalten und bei einem Anschluss an den Spannungswandler das Korrekturglied bei Bedarf auszuschalten. Auch im Fall des induktiven Spannungswandlers könnte hier das Korrekturglied eingeschaltet bleiben, wobei dessen inverse Übertragungsfunktion entsprechend geändert werden müsste. Dies wäre insbesondere bei einem digitalen Filter mit zeitdiskreter Übertragungsfunktion als Korrekturglied durch Einstellung der Koeffizienten auf einfache Weise durchführbar.

Je nachdem, ob das Ausgangssignal der Messschaltung ein analoges oder ein digitales Ausgangssignal ist, ist entsprechend ein analoges Filter mit PID-Charakteristik oder ein digitales Filter einzusetzen.

Eine vorteilhafte Weiterbildung der erfindungsgemäßen Messvorrichtung sieht vor, dass die Weiterverarbeitungsanordnung in ihrem Eingangsbereich ein galvanisches Trennelement aufweist. Auf diese Weise lassen sich problemlos Hoch- und Niederspannungsteil der Messvorrichtung galvanisch trennen. Vorzugsweise kann es sich bei dem galvanischen Trennelement um einen induktiven Stromwandler handeln.

Gemäß einer weiteren vorteilhaften Weiterbildung der erfindungsgemäßen Messvorrichtung ist der Spannungsgeber ausgangsseitig an eine Reihenschaltung aus einem hochohmigen Widerstand und der Primärwicklung des induktiven Stromwandlers angeschlossen. Über den hochohmigen Widerstand findet eine Umsetzung der Eingangsspannung der Weiterverarbeitungsanordnung in einen vergleichsweise geringen Strom statt, so dass der induktive Stromwandler verhältnismäßig klein und damit kostengünstig ausgeführt sein kann.

Ein weitere vorteilhafte Weiterbildung der erfindungsgemäßen Messvorrichtung sieht ferner vor, dass die Sekundärwicklung des Stromwandlers durch einen gegengekoppelten Operationsverstärker mit einem Innenwiderstand von 0 Ohm belastet ist. Mit dem Operationsverstärker findet wiederum eine Strom-Spannungs-Umsetzung statt, wobei durch die Gegenkopplung des Operationsverstärkers der Bereich der Höhe der resultierenden Spannung z. B. über einen im Gegenkopplungszweig angeordneten Widerstand einstellbar ist.

Ferner wird als vorteilhafte Ausführungsform der erfindungsgemäßen Messvorrichtung angesehen, dass die Messschaltung ausgangsseitig einen Analog/Digital-Wandler aufweist, um digitale Ausgangssignale der Messanordnung zu erzeugen.

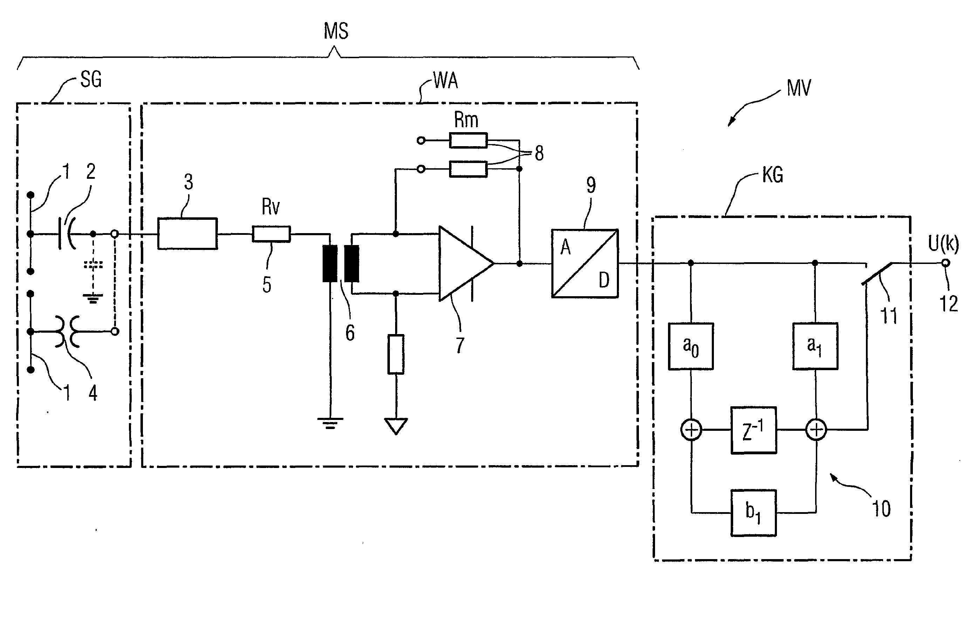

Die Erfindung wird im Folgenden anhand eines in der Figur dargestellten Ausführungsbeispiels näher erläutert. Die Figur zeigt das Schaltbild einer Messvorrichtung MV zur Spannungsmessung mit einem digitalen Filter als Korrekturglied KG zur Korrektur der Spannungsmesswerte.

Ein Stromleiter 1 eines Stromverteilungsnetzes bildet eine Elektrode eines kapazitiven Spannungswandlers als Spannungsgeber SG in Form eines Hochspannungs-Koppelkondensators 2. Die andere Elektrode des Koppelkondensators 2, die vorzugsweise galvanisch getrennt von dem Stromleiter 1 ringförmig um diesen herumgeführt ist, ist mit einer Eingangsklemme 3 einer Weiterverarbeitungsanordnung WA der Messvorrichtung MV verbunden. Analog dazu sind als Spannungsgeber SG aber auch weitere Formen kapazitiver Spannungswandler möglich. Wie in der Figur angedeutet, kann es sich bei dem kapazitiven Spannungswandler optional um einen kapazitiven Teiler handeln, dessen Unterspannungskondensator in der Figur strichliert dargestellt ist. Eine Ausführung als kapazitiver Teiler ist jedoch nicht zwingend notwendig. Stattdessen kann, wie durch die weitere strichlierte Linie angedeutet ist, auch die Sekundärwicklung eines primärseitig an den Stromleiter 1 angeschlossenen induktiven Spannungswandlers 4 mit der Eingangsklemme 3 der Weiterverarbeitungsanordnung WA verbunden sein.

Wie in der Figur durch die geschweifte Klammer angedeutet ist, bilden Spannungsgeber SG und Weiterverarbeitungsanordnung WA gemeinsam eine sogenannte Messschaltung MS.

Im Folgenden wird der Fall betrachtet, dass der Koppelkondensator 2 als Spannungsgeber SG mit der Eingangsklemme 3 der Weiterverarbeitungsanordnung WA verbunden ist. Ein hinter der Eingangsklemme 3 angeordneter, üblicherweise hochohmiger Vorwiderstand 5 (Rv) führt eine Spannungs-/Strom-Umwandlung der an der galvanisch vom Stromleiter 1 getrennten Elektrode des Koppelkondensators 2 kapazitiv abgegriffenen Spannung in einen Verschiebestrom durch. Zusätzlich bildet der Vorwiderstand 5 mit der Kapazität des Koppelkondensators 2 einen Hochpass und verbessert daher das eingangsseitige EMV (elektromagnetische Verträglichkeit)-Verhalten der Messvorrichtung MV.

Ein primärseitig in Reihe mit dem Vorwiderstand 5 geschaltetes galvanisches Trennelement in Form eines induktiven Stromwandlers 6 dient einerseits der Potentialtrennung und andererseits der Verringerung der Koppelkapazität gegenüber dem Hochspannungsleiter und bewirkt somit eine weitere EMV-Abschirmung. Aufgrund des durch die Bemessung des Vorwiderstands 5 geringen Verschiebestroms kann der induktive Stromwandler 6 vergleichsweise klein ausgebildet werden.

An die Sekundärseite des induktiven Stromwandlers 6 schließt sich ein Operationsverstärker 7 mit einem Rückkopplungswiderstand 8 (Rm) an. Der Operationsverstärker 7 dient als aktive Bürde für den induktiven Stromwandler 6 mit einem Innenwiderstand von 0 Ohm. Gleichzeitig übernimmt der Operationsverstärker 7 eine Strom-/Spannungs-Umwandlung und übersetzt den von dem induktiven Stromwandler 6 gelieferten Strom in eine Spannung. Das Verhältnis von Ausgangsspannung zu Eingangsstrom des Operationsverstärkers 7 wird durch den Wert Rm des Rückkopplungswiderstandes 8 bestimmt. Dieser Wert kann durch eine Brücke oder einen Analogschalter wie in der Figur angedeutet umgeschaltet werden, um die vom Koppelkondensator 2 oder Spannungswandler 3 abhängige Ansteuerung des Stromwandlers 6 an den Messbereich eines dem Operationsverstärker 7 nachfolgenden Analog/Digital-Wandlers 9 anpassen zu können.

Dieser setzt seine Eingangsspannung in eine digitale Abtastwertfolge um.

Ist die Eingangsklemme 3 der Weiterverarbeitungsanordnung WA mit dem induktiven Spannungswandler 4 verbunden, dann ist das Übertragungsverhalten der aus Spannungsgeber SG (in diesem Fall also dem induktiven Spannungswandler 4) und Weiterverarbeitungsanordnung WA gebildeten Messschaltung MS im relevanten Frequenzbereich (50 bzw. 60 Hz) von der Frequenz unabhängig.

Demgegenüber ergibt sich bei einem Anschluss an den Koppelkondensator 2 die folgende Übertragungsfunktion der Messschaltung MS bis zum Analog/Digital-Wandler 9:

$$\frac{U_A}{U_{Prim}} = \frac{j\omega C_D \cdot R_m}{1 + j\omega C_D \cdot R_v}$$

Hierin bedeuten $U_A$ die Spannung am Ausgang des Operationsverstärkers 7, $U_{Prim}$ die Spannung des Stromleiters 1 und $C_D$ die Kapazität des Koppelkondensators 2. Lässt man den sich anhand dieser Übertragungsfunktion ergebenden Wert von $U_A$ unverändert, dann erhält man einen für eine genaue Spannungsmessung völlig ungeeigneten Spannungsmesswert. Die Übertragungsfunktion der gesamten Messvorrichtung MV (bestehend aus Spannungsgeber SG, Weiterverarbeitungsanordnung WA und Korrekturglied KG) muss daher durch ein nachgeschaltetes Korrekturglied KG mittels einer zu der Übertragungsfunktion der Messschaltung MS inversen Übertragungsfunktion korrigiert werden. Diese korrigierende inverse Übertragungsfunktion des Korrekturglieds KG sollte nach folgender Gleichung gebildet werden:

$$G_{korr} = \frac{1 + j\omega C_D \cdot R_v}{1 + j\omega T_K}$$

Die resultierende Übertragungsfunktion der gesamten Messvorrichtung MV stellt wiederum einen Hochpass dar, jedoch mit einer neuen Eckfrequenz 1/(2*pi*$T_K$). Die Zeitkonstante $T_K$ ist dann so zu wählen, dass die Eckfrequenz unterhalb des zu erfassenden Frequenzbereichs der Spannungsmessgröße liegt, so dass die Übertragungsfunktion der gesamten Messvorrichtung MV in diesem Frequenzbereich linear verläuft. Besonders vorteilhaft ist es, wenn $T_K$ gleich der Zeitkonstanten der eingesetzten Stromwandler zur Erfassung der Stromsignale, die parallel zum Spannungssignal ebenfalls gemessen werden, gewählt wird.

Wenn, wie in der Figur gezeigt, ein digitales Filter 10 zur Korrektur der Übertragungsfunktion der Messschaltung MS verwendet wird, ist die korrigierende Übertragungsfunktion $G_{korr}$ zuvor in eine zeitdiskrete Übertragungsfunktion $G(z^{-1})$ zu transformieren. Dies erfolgt mit Hilfe der Bilineartransformation

$$e^{-j\omega T_A} = \frac{2}{T_A} \cdot \frac{z+1}{z-1} .$$

Die rechte Seite dieser Gleichung ist die nach dem ersten Glied abgebrochene Reihenentwicklung der Funktion $e^{-j\omega \cdot T}$. Hiermit wird erhalten:

$$G(z^{-1}) = \frac{a_1 z^{-1} + a_0}{1 + b_1 z^{-1}} .$$

Hierin bedeutet $z^{-1}$ die Verzögerung eines Abtastwertes um ein Abtastintervall; $a_0$, $a_1$ und $b_1$ sind Koeffizienten der zeitdiskreten Übertragungsfunktion. Diese zeitdiskrete Übertragungsfunktion $G(z^{-1})$ wird durch das in der Figur dargestellte digitale Filter 10 realisiert. Dieses hat weiterhin eine endliche Verstärkung bei der Frequenz 0, so dass die numerische Stabilität der Vorrichtung auch bei einem Offset des Analog/Digital-Wandlers 9 gesichert ist.

Ein Schalter 11 dient zum Verbinden des Ausgangs des Analog/Digital-Wandlers 9 mit dem Messwertausgang 12 der Messvorrichtung MV entweder direkt oder über das digitale Filter 10. Die direkte Verbindung kann gewählt werden, wenn der induktive Spannungswandler 4 als Spannungsgeber SG an die Eingangsklemme 3 der Weiterverarbeitungsanordnung WA angeschlossen ist, und die Verbindung über das digitale Filter 10 wird gewählt, wenn der Koppelkondensator 2 als Spannungsgeber SG an die Eingangsklemme 3 angeschlossen ist. Der Schalter 11 könnte jedoch auch wegfallen, so dass in beiden Fällen das digitale Filter 10 einbezogen ist, da auch bei Verwendung des induktiven Spannungswandlers 4 durch die Verschiebung der Eckfrequenz der Übertragungsfunktion der gesamten Messvorrichtung MV eine Verbesserung der Qualität der Spannungsmesswerte erreicht werden kann. Es sind dann jedoch für den Anschluss an den induktiven Spannungswandler 4 einerseits und an den Koppelkondensator 2 andererseits die Koeffizienten des digitalen Filters 10 jeweils unterschiedlich einzustellen.

Entsprechend ist auch eine Messvorrichtung mit analogen Spannungssignalen realisierbar, an die Stelle des digitalen Filters träte in diesem Fall ein analoges Filter, der A-D-Wandler entfiele.

**Patentansprüche**

1. Verfahren zum Messen einer Spannung an einer Stelle eines Stromverteilungsnetzes mittels einer Messschaltung (MS), die einen mit einem stromführenden Leiter (1) des Netzes gekoppelten Spannungsgeber (SG) und eine an den Spannungsgeber (SG) angeschlossene Weiterverarbeitungsanordnung (WA) aufweist und an ihrem Ausgang einen Spannungsmesswert als Ausgangssignal abgibt, wobei das Ausgangssignal der Messschaltung (MS) zur Erzielung eines korrekten Messwertes durch ein Korrekturglied (KG) mit einer Übertragungsfunktion, die zu der Übertragungsfunktion der Messschaltung (MS) invers ist, korrigiert wird, und wobei als Korrekturglied (KG) ein elektronisches Filter mit einer an die jeweilige Übertragungsfunktion der Messschaltung (MS) angepassten Übertragungsfunktion verwendet wird,
**dadurch gekennzeichnet, dass**

   - die Messschaltung (MS) wahlweise an einen induktiven Spannungswandler (4) als Spannungsgeber (SG) oder eine Kondensatoreinrichtung als Spannungsgeber (SG) anschließbar ist, und
   - das Korrekturglied (KG) über einen Schalter (11) wahlweise überbrückbar ist, wobei es bei Verwendung der Kondensatoreinrichtung als Spannungsgeber (SG) über den Schalter (11) eingeschaltet und bei Verwendung des induktiven Spannungswandlers (4) als Spannungsgeber (SG) über den Schalter (11) ausgeschaltet wird.

2. Verfahren nach Anspruch 1,
**dadurch gekennzeichnet, dass**
als Kondensatoreinrichtung ein aus dem stromführenden Leiter (1) des Netzes und einer galvanisch von diesem getrennten Elektrode gebildeter Koppelkondensator (2) verwendet wird.

3. Verfahren nach Anspruch 1 oder 2,
**dadurch gekennzeichnet, dass**
bei einem analogen Ausgangssignal der Messschaltung (MS) die Korrektur durch ein analoges Filter mit PID-Charakteristik als Korrekturglied (KG) durchgeführt wird.

4. Verfahren nach Anspruch 1 oder 2,
**dadurch gekennzeichnet, dass**
bei einem digitalen Ausgangssignal der Messschaltung (MS) die Korrektur durch ein digitales Filter (10) als Korrekturglied (KG) durchgeführt wird.

5. Verfahren nach Anspruch 4,
**dadurch gekennzeichnet, dass**
ein digitales Filter (10) verwendet wird, bei dem die inverse Übertragungsfunktion durch eine zeitdiskrete Übertragungsfunktion dargestellt wird.

6. Verfahren nach Anspruch 5,
**dadurch gekennzeichnet, dass**
ein digitales Filter (10) verwendet wird, bei dem die Koeffizienten der zeitdiskreten Übertragungsfunktion veränderbar sind.

7. Verfahren nach einem der vorangehenden Ansprüche,
**dadurch gekennzeichnet, dass**
eine Weiterverarbeitungsanordnung (WA) verwendet wird, die in ihrem Eingangsbereich ein galvanisches Trennelement aufweist.

8. Messvorrichtung (MV) zum Messen einer Spannung an einer Stelle eines Stromverteilungsnetzes mittels einer Messschaltung (MS), die einen mit einem stromführenden Leiter (1) des Netzes gekoppelten Spannungsgeber (SG) und eine an den Spannungsgeber (SG) angeschlossene Weiterverarbeitungsanordnung (WA) aufweist und an ihrem Ausgang einen Spannungsmesswert als Ausgangssignal abgibt, wobei zur Erzielung eines korrekten Messwertes aus dem Ausgangssignal der Messschaltung (MS) mit der Messschaltung (MS) ausgangsseitig ein Korrekturglied (KG) verbunden ist, das eine Übertragungsfunktion aufweist, die invers zur Übertragungsfunktion der Messschaltung (MS) ist und wobei das Korrekturglied (KG) ein elektronisches Filter mit einer an die jeweilige Übertragungsfunktion der Messschaltung angepassten Übertragungsfunktion ist,
**dadurch gekennzeichnet, dass**

- die Messschaltung (MS) wahlweise an einen induktiven Spannungswandler (4) als Spannungsgeber (SG) oder eine Kondensatoreinrichtung als Spannungsgeber (SG) anschließbar ist, und
- das Korrekturglied (KG) über einen Schalter (11) wahlweise überbrückbar ist, wobei es bei Verwendung der Kondensatoreinrichtung als Spannungsgeber (SG) über den Schalter (11) eingeschaltet und bei Verwendung des induktiven Spannungswandlers (4) als Spannungsgeber (SG) ausgeschaltet ist.

9. Messvorrichtung (MV) nach Anspruch 8,
**dadurch gekennzeichnet, dass**
die Kondensatoreinrichtung ein aus dem stromführenden Leiter (1) des Netzes und einer galvanisch von diesem getrennten Elektrode gebildeter Koppelkondensator (2) ist.

10. Messvorrichtung (MV) nach Anspruch 9,
**dadurch gekennzeichnet, dass**
die Elektrode des Koppelkondensators (2) eine den stromführenden Leiter (1) umgebende Ringelektrode ist.

11. Messvorrichtung (MV) nach einem der Ansprüche 8 bis 10,
**dadurch gekennzeichnet, dass**
bei einem analogen Ausgangssignal der Messschaltung (MS) das Korrekturglied (KG) ein analoges Filter mit PID-Charakteristik ist.

12. Messvorrichtung (MV) nach einem der Ansprüche 8 bis 10,
**dadurch gekennzeichnet, dass**
bei einem digitalen Ausgangssignal der Messschaltung (MS) das Korrekturglied (KG) ein digitales Filter (10) ist.

13. Messvorrichtung (MV) nach Anspruch 12,
**dadurch gekennzeichnet, dass**
die Übertragungsfunktion des digitalen Filters (10) durch eine zeitdiskrete Übertragungsfunktion dargestellt ist.

14. Messvorrichtung (MV) nach Anspruch 13,
**dadurch gekennzeichnet, dass**
das digitale Filter (10) eine zeitdiskrete Übertragungsfunktion mit veränderbaren Koeffizienten aufweist.

15. Messvorrichtung (MV) nach einem der Ansprüche 8 bis 14,
**dadurch gekennzeichnet, dass**
die Weiterverarbeitungsanordnung (WA) in ihrem Eingangsbereich ein galvanisches Trennelement aufweist.

16. Messvorrichtung (MV) nach Anspruch 15,
**dadurch gekennzeichnet, dass**
das galvanische Trennelement ein induktiver Stromwandler (6) ist.

17. Messvorrichtung (MV) nach Anspruch 16,
**dadurch gekennzeichnet, dass**
der Spannungsgeber (SG) ausgangsseitig an eine Reihenschaltung aus einem hochohmigen Widerstand (5) und der Primärwicklung des induktiven Stromwandlers (6) angeschlossen ist.

18. Messvorrichtung (MV) nach einem der Ansprüche 16 oder 17,
**dadurch gekennzeichnet, dass**
die Sekundärwicklung des Stromwandlers (6) durch einen gegengekoppelten Operationsverstärker (7) mit einem Innenwiderstand von 0 Ohm belastet ist.

19. Messvorrichtung (MV) nach einem der Ansprüche 8 bis 10 und 12 bis 18,

**dadurch gekennzeichnet, dass**
die Messschaltung (MS) ausgangsseitig einen Analog/Digital-Wandler (9) aufweist.

## Claims

1. Method for measuring the voltage at a point of a current distribution network by means of a measuring circuit (MS), which has a voltage transmitter (SG) which is coupled to a current-carrying conductor (1) of the network, and a further processing arrangement (WA), which is connected to the voltage transmitter (SG) and which outputs a voltage measurement as an output signal at the output thereof, wherein, in order to achieve a correct measurement, the output signal of the measuring circuit (MS) is corrected by a correction element (KG) having a transfer function, which is the inverse of the transfer function of the measuring circuit (MS), and wherein an electronic filter having a transfer function, which is matched to the respective transfer function of the measuring circuit (MS) is used as the correction element (KG), **characterized in that**

    - the measuring circuit (MS) can optionally be connected to an inductive voltage transformer (4) as voltage transmitter (SG) or to a capacitor unit as voltage transmitter (SG), and
    - the correction element (KG) can optionally be bridged by a switch (11), wherein said correction element is switched on by means of the switch (11) when the capacitor unit is used as voltage transmitter (SG) and is switched off by means of the switch (11) when the inductive voltage transformer (4) is used as voltage transmitter (SG).

2. Method according to Claim 1, **characterized in that** a coupling capacitor (2), which is formed from the current-carrying conductor (1) of the network and an electrode, which is galvanically isolated therefrom, is used as the capacitor unit.

3. Method according to Claim 1 or 2, **characterized in that**, in the case of an analogue output signal of the measuring circuit (MS), the correction is carried out by an analogue filter with PID characteristic as correction element (KG).

4. Method according to Claim 1 or 2, **characterized in that**, in the case of a digital output signal of the measuring circuit (MS), the correction is carried out by a digital filter (10) as correction element (KG).

5. Method according to Claim 4, **characterized in that** a digital filter (10) is used in which the inverse transfer function is represented by a time-discrete transfer function.

6. Method according to Claim 5, **characterized in that** a digital filter (10) is used in which the coefficients of the time-discrete transfer function can be changed.

7. Method according to one of the preceding claims, **characterized in that** a further processing arrangement (WA) is used, which has a galvanic isolating element in its input region.

8. Measuring device (MV) for measuring the voltage at a point of a current distribution network by means of a measuring circuit (MS), which has a voltage transmitter (SG) which is coupled to a current-carrying conductor (1) of the network, and a further processing arrangement (WA), which is connected to the voltage transmitter (SG) and which outputs a voltage measurement as an output signal at the output thereof, wherein, in order to achieve a correct measurement from the output signal of the measuring circuit (MS), a correction element (KG) having a transfer function, which is the inverse of the transfer function of the measuring circuit (MS), is connected on the output side to the measuring circuit (MS), and wherein the correction element (KG) is an electronic filter having a transfer function, which is matched to the respective transfer function of the measuring circuit, **characterized in that**

    - the measuring circuit (MS) can optionally be connected to an inductive voltage transformer (4) as voltage transmitter (SG) or to a capacitor unit as voltage transmitter (SG), and
    - the correction element (KG) can optionally be bridged by a switch (11), wherein said correction element is switched on by means of the switch (11) when the capacitor unit is used as voltage transmitter (SG) and is switched off when the inductive voltage transformer (4) is used as voltage transmitter (SG).

9. Measuring device (MV) according to Claim 8, **characterized in that** the capacitor unit is a coupling capacitor (2) formed from the current-carrying conductor (1) of the network and an electrode, which is galvanically isolated therefrom.

10. Measuring device (MV) according to Claim 9, **characterized in that** the electrode of the coupling capacitor (2) is a ring electrode surrounding the current-carrying conductor (1).

11. Measuring device (MV) according to one of Claims 8 to 10, **characterized in that**, in the case of an analogue output signal of the measuring circuit (MS), the correction element (KG) is an analogue filter with PID characteristic.

**12.** Measuring device (MV) according to one of Claims 8 to 10, **characterized in that**, in the case of a digital output signal of the measuring circuit (MS), the correction element (KG) is a digital filter (10).

**13.** Measuring device (MV) according to Claim 12, **characterized in that** the transfer function of the digital filter (10) is represented by a time-discrete transfer function.

**14.** Measuring device (MV) according to Claim 13, **characterized in that** the digital filter (10) has a time-discrete transfer function with variable coefficients.

**15.** Measuring device (MV) according to one of Claims 8 to 14, **characterized in that** the further processing arrangement (WA) has a galvanic isolating element in its input region.

**16.** Measuring device (MV) according to Claim 15, **characterized in that** the galvanic isolating element is an inductive current transformer (6).

**17.** Measuring device (MV) according to Claim 16, **characterized in that** the voltage transmitter (SG) is connected on the output side to a series circuit consisting of a high-resistance resistor (5) and the primary winding of the inductive current transformer (6).

**18.** Measuring device (MV) according to one of Claims 16 or 17, **characterized in that** the secondary winding of the current transformer (6) is loaded by an operational amplifier (7) having negative feedback and an internal resistance of 0 Ohm.

**19.** Measuring device (MV) according to one of Claims 8 to 10 and 12 to 18, **characterized in that** the measuring circuit (MS) has an analogue/digital converter (9) on the output side.

**Revendications**

**1.** Procédé de mesure d'une tension en un point d'un réseau de distribution de courant au moyen d'un circuit de mesure (MS) qui comporte un transmetteur de tension (SG) couplé à un conducteur de courant (1) du réseau et un dispositif de traitement (WA) raccordé au transmetteur de tension (SG) et qui délivre à sa sortie une valeur mesurée de tension comme signal de sortie, dans lequel le signal de sortie du circuit de mesure (MS) est corrigé pour obtenir une valeur mesurée correcte par un élément de correction (KG) ayant une fonction de transfert qui est l'inverse de la fonction de transfert du circuit de mesure (MS), et dans lequel un filtre électronique ayant une fonction de transfert adaptée à la fonction de transfert respective du circuit de mesure (MS) est utilisé comme élément de correction (KG),
**caractérisé par le fait que**

- on peut raccorder le circuit de mesure (MS) sélectivement à un transformateur de tension inductif (4) comme transmetteur de tension (SG) ou à un dispositif condensateur comme transmetteur de tension (SG), et
- on peut ponter l'élément de correction (KG) sélectivement par l'intermédiaire d'un commutateur (11), l'élément de correction étant mis en circuit par l'intermédiaire du commutateur (11) lors de l'utilisation du dispositif condensateur comme transmetteur de tension (SG) et étant mis hors circuit par l'intermédiaire du commutateur (11) lors de l'utilisation du transformateur de tension inductif (4) comme transmetteur de tension (SG).

**2.** Procédé selon la revendication 1,
**caractérisé par le fait que** l'on utilise comme dispositif condensateur un condensateur de couplage (2) formé du conducteur de courant (1) du réseau et d'une électrode isolée électriquement de celui-ci.

**3.** Procédé selon la revendication 1 ou 2,
**caractérisé par le fait que**, lorsque le signal de sortie du circuit de mesure (MS) est analogique, on effectue la correction au moyen d'un filtre analogique avec caractéristique PID comme élément de correction (KG).

**4.** Procédé selon la revendication 1 ou 2,
**caractérisé par le fait que**, lorsque le signal de sortie du circuit de mesure (MS) est numérique, on effectue la correction au moyen d'un filtre numérique (10) comme élément de correction (KG).

**5.** Procédé selon la revendication 4,
**caractérisé par le fait que** l'on utilise un filtre numérique (10) tel que la fonction de transfert inverse est représentée par une fonction de transfert discrète dans le temps.

**6.** Procédé selon la revendication 5,
**caractérisé par le fait que** l'on utilise un filtre numérique (10) tel que les coefficients de la fonction de transfert discrète dans le temps sont modifiables.

**7.** Procédé selon l'une des revendications précédentes,
**caractérisé par le fait que** l'on utilise un dispositif de traitement (WA) qui comporte dans sa zone d'entrée un élément d'isolation électrique.

**8.** Dispositif de mesure (MV) pour mesurer une tension en un point d'un réseau de distribution de courant au moyen d'un circuit de mesure (MS) qui comporte un transmetteur de tension (SG) couplé à un conducteur de courant (1) du réseau et un dispositif de traitement (WA) raccordé au transmetteur de tension (SG) et qui délivre à sa sortie une valeur mesurée de tension comme signal de sortie, dans lequel, pour obtenir une valeur mesurée correcte à partir du signal de sortie du circuit de mesure (MS), un élément de correction (KG) ayant une fonction de transfert qui est l'inverse de la fonction de transfert du circuit de mesure (MS) est relié au circuit de mesure (MS) côté sortie, et dans lequel l'élément de correction (KG) est un filtre électronique ayant une fonction de transfert adaptée à la fonction de transfert respective du circuit de mesure,
**caractérisé par le fait que**

- le circuit de mesure (MS) peut être raccordé sélectivement à un transformateur de tension inductif (4) comme transmetteur de tension (SG) ou à un dispositif condensateur comme transmetteur de tension (SG), et
- l'élément de correction (KG) peut être ponté sélectivement par l'intermédiaire d'un commutateur (11), l'élément de correction étant mis en circuit par l'intermédiaire du commutateur (11) lors de l'utilisation du dispositif condensateur comme transmetteur de tension (SG) et étant mis hors circuit lors de l'utilisation du transformateur de tension inductif (4) comme transmetteur de tension (SG).

**9.** Dispositif de mesure (MV) selon la revendication 8, **caractérisé par le fait que** le dispositif condensateur est un condensateur de couplage (2) formé du conducteur de courant (1) du réseau et d'une électrode isolée électriquement de celui-ci.

**10.** Dispositif de mesure (MV) selon la revendication 9, **caractérisé par le fait que** l'électrode du condensateur de couplage (2) est une électrode annulaire entourant le conducteur de courant (1).

**11.** Dispositif de mesure (MV) selon l'une des revendications 8 à 10,
**caractérisé par le fait que**, lorsque le signal de sortie du circuit de mesure (MS) est analogique, l'élément de correction (KG) est un filtre analogique avec caractéristique PID.

**12.** Dispositif de mesure (MV) selon l'une des revendications 8 à 10,
**caractérisé par le fait que**, lorsque le signal de sortie du circuit de mesure (MS) est numérique, l'élément de correction (KG) est un filtre numérique (10).

**13.** Dispositif de mesure (MV) selon la revendication 12, **caractérisé par le fait que** la fonction de transfert du filtre numérique (10) est représentée par une fonction de transfert discrète dans le temps.

**14.** Dispositif de mesure (MV) selon la revendication 13, **caractérisé par le fait que** le filtre numérique (10) a une fonction de transfert discrète dans le temps avec des coefficients modifiables.

**15.** Dispositif de mesure (MV) selon l'une des revendications 8 à 14,
**caractérisé par le fait que** le dispositif de traitement (WA) comporte dans sa zone d'entrée un élément d'isolation électrique.

**16.** Dispositif de mesure (MV) selon la revendication 15, **caractérisé par le fait que** l'élément d'isolation électrique est un transformateur de courant inductif (6).

**17.** Dispositif de mesure (MV) selon la revendication 16, **caractérisé par le fait que** le transmetteur de tension (SG) est raccordé côté sortie à un circuit série composé d'une résistance à grande valeur ohmique (5) et de l'enroulement primaire du transformateur de courant inductif (6).

**18.** Dispositif de mesure (MV) selon l'une des revendications 16 ou 17,
**caractérisé par le fait que** l'enroulement secondaire du transformateur de courant (6) est chargé par un amplificateur opérationnel à contre-réaction (7) avec une résistance interne de 0 Ohm.

**19.** Dispositif de mesure (MV) selon l'une des revendications 8 à 10 et 12 à 18,
**caractérisé par le fait que** le circuit de sortie (MS) comporte côté sortie un convertisseur analogique - numérique (9).

U(k)
12
11
10
MV
KG
a1
a0
z-1
b1
MS
WA
SG
9
A
D
8
Rm
7
6
Rv
5
3
2
1
4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 2325449 A1
- US 3870927 A
- US 5068598 A
- US 20020171433 A1
- US 6236949 B1